(19) Europäisches Patentamt
European Patent Office
Office européen des brevets

(11) EP 4 501 624 A1

(12) # EUROPEAN PATENT APPLICATION
published in accordance with Art. 153(4) EPC

(43) Date of publication:
**05.02.2025 Bulletin 2025/06**

(21) Application number: **23778618.1**

(22) Date of filing: **28.03.2023**

(51) International Patent Classification (IPC):
***B32B 15/088*** *(2006.01)* ***H05K 1/03*** *(2006.01)*

(52) Cooperative Patent Classification (CPC):
**B32B 15/088; H05K 1/03**

(86) International application number:
**PCT/IB2023/053046**

(87) International publication number:
**WO 2023/187624 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.03.2022 JP 2022054761**

(71) Applicant: **Fujimori Kogyo Co., Ltd.**
**Tokyo 112-0002 (JP)**

(72) Inventors:
- **NOMURA, Tadahiro**
  **Tokyo 112-0002 (JP)**
- **SAKURAGI, Takanori**
  **Tokyo 112-0002 (JP)**
- **TAKEI, Kunihiro**
  **Tokyo 112-0002 (JP)**

(74) Representative: **Godemeyer Blum Lenze Patentanwälte**
**Partnerschaft mbB - werkpatent**
**An den Gärten 7**
**51491 Overath (DE)**

(54) **ADHESIVE-EQUIPPED METAL SUBSTRATE AND LAMINATE**

(57) The present invention relates to an adhesive-attached metal substrate and a laminate which have low dielectric properties in a high frequency region and can sufficiently ensure adhesive strength between a resin film and a metal layer. More specifically, the present invention relates to an adhesive-attached metal substrate including a metal layer and an adhesive resin layer formed of an adhesive resin composition, in which the adhesive resin composition contains a polyimide resin (A), a maleimide compound (B), a radical initiator, and an epoxy resin, a mass ratio between the polyimide resin (A) and the maleimide compound (B) is 10:1 to 3:2, the content of the radical initiator, with respect to 100 parts by mass of the maleimide compound (B), is equal to or more than 1 part by mass and less than 15 parts by mass, and the content of the epoxy resin, with respect to 100 parts by mass of the polyimide resin (A) and the maleimide compound (B) in total, is 1 part by mass or more and 5 parts by mass or less; and a laminate including the adhesive-attached metal substrate.

Fig. 1

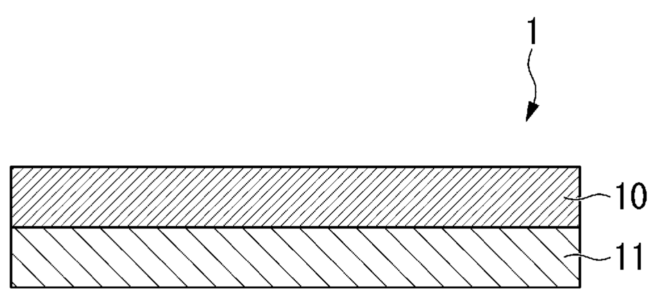




Processed by Luminess, 75001 PARIS (FR)

## Description

### TECHNICAL FIELD

The present invention relates to an adhesive-attached metal substrate and a laminate.

### BACKGROUND ART

In recent years, with an increase in the speed of a transmission signal represented by the 5th Generation Mobile Communication System (so-called 5G), the frequency of a signal exceeding 6 GHz has been increased. Accordingly, a flexible printed circuit (FPC) for high speed transmission is required to have low dielectric properties (low dielectric constant and low dielectric loss tangent) in a high frequency region.

For example, Patent Literature 1 discloses a laminate in which a resin substrate and a metal substrate are laminated with an adhesive layer interposed therebetween, assuming use in a printed wiring board. The adhesive layer included in the laminate disclosed in Patent Literature 1 has a relative permittivity of 3.0 or less and a dielectric loss tangent of 0.02 or less at a frequency of 1 MHz, which is in a low frequency band with respect to the frequency band of the 5G.

### CITATION LIST

#### Patent Literature

Patent Literature 1: Japanese Unexamined Patent Application, First Publication No. 2021-003886

### SUMMARY OF INVENTION

### TECHNICAL PROBLEM

In high frequency transmission, a current flows only on the surface of metal wiring as the frequency band becomes higher. Therefore, if the shape of the surface is not smooth, a transmission loss increases. This is a known phenomenon called a "skin effect". In order to reduce the transmission loss caused by the skin effect, for example, a metal foil having a small surface roughness tends to be used for a metal substrate.

As the surface roughness of a metal foil decreases, an anchor effect is less likely to be obtained, and adhesion between a resin film and a metal foil decreases. In this case, an FPC has a problem in that circuit peeling easily occurs, and the circuit easily falls off due to bending stress.

The present invention has been made in view of the above circumstances, and an object of the present invention is to provide an adhesive-attached metal substrate and a laminate which have low dielectric properties in a high frequency region and can sufficiently ensure adhesive strength between a resin film and a metal layer.

### SOLUTION TO PROBLEM

That is, the present invention employs the following configurations.

[1] An adhesive-attached metal substrate including a metal layer and an adhesive resin layer formed of an adhesive resin composition, in which the adhesive resin composition contains a polyimide resin (A), a maleimide compound (B), a radical initiator, and an epoxy resin, a mass ratio between the polyimide resin (A) and the maleimide compound (B) is 10:1 to 3:2, the content of the radical initiator, with respect to 100 parts by mass of the maleimide compound (B), is equal to or more than 1 part by mass and less than 15 parts by mass, and the content of the epoxy resin, with respect to 100 parts by mass of the polyimide resin (A) and the maleimide compound (B) in total, is 1 part by mass or more and 5 parts by mass or less.

[2] The adhesive-attached metal substrate according to [1], in which the metal layer is a copper foil having a surface roughness of 1.5 μm or less.

[3] The adhesive-attached metal substrate according to [1] or [2], in which the adhesive resin layer has a thickness of 1 μm or more and 15 μm or less.

[4] A laminate including the adhesive-attached metal substrate according to any one of [1] to [3] on one surface or both surfaces of a resin film, in which the resin film is laminated on a surface opposite a surface on which the adhesive resin layer included in the adhesive-attached metal substrate is in contact with the metal layer, and the resin film is one or more selected from the group consisting of a modified polyimide resin film, a polyester resin film, a liquid crystal polymer film, a cyclic olefin resin film, a polyphenylene ether resin film, a polyphenylene sulfide resin film, a polyether

ether ketone resin film, a bismaleimide resin film, a triazine resin film, a benzocyclobutene resin film, and a low dielectric epoxy resin film.

ADVANTAGEOUS EFFECTS OF INVENTION

According to the present invention, there can be provided an adhesive-attached metal substrate and a laminate which have low dielectric properties in a high frequency region and can sufficiently ensure adhesive strength between a resin film and a metal layer.

BRIEF DESCRIPTION OF DRAWINGS

Fig. 1 is a schematic cross-sectional view of an example of an adhesive-attached metal substrate according to the present embodiment.
Fig. 2 is a schematic cross-sectional view of an example of a laminate according to the present embodiment.

DESCRIPTION OF EMBODIMENTS

<Adhesive-attached metal substrate>

Fig. 1 illustrates a cross-sectional schematic view of an adhesive-attached metal substrate 1 according to the present embodiment. The adhesive-attached metal substrate 1 includes a metal layer 10 and an adhesive resin layer 11.
By combining and thermally laminating the adhesive-attached metal substrate 1 and an optional low dielectric substrate, an FPC or a rigid substrate for high speed transmission can be produced.
When, for example, a polyimide resin film or a modified polyimide resin film is used as a low dielectric substrate, an FPC is obtained.
For example, when a prepreg including a polyphenylene ether resin is used as a low dielectric substrate, a rigid substrate can be produced.

(Metal layer 10)

For the metal layer 10, any known conductive material usable for a circuit board can be used. Specifically, it is a metal material such as SUS, copper, aluminum, iron, steel, zinc, or nickel, or an alloy of the metal material.
The metal layer 10 is preferably a metal foil and more preferably a copper foil.
When the metal layer 10 is a copper foil, a rolled copper foil or an electrolytic copper foil as a copper foil can be used. When excellent bending properties (for example, bending properties of one million times or more) are required in an FPC, it is preferable to use a rolled copper foil.
As a material of the copper foil, pure copper or a copper alloy in which a small amount of tin (Sn) or silver (Ag) is added to pure copper may be used.
The metal layer 10 is preferably a metal foil having a surface roughness of 1.5 μm or less, more preferably a metal foil having a surface roughness of 1.4 μm or less, and particularly preferably a metal foil having a surface roughness of 1.3 μm or less.
When the metal layer 10 is a copper foil, it may be a low-roughened copper foil or a non-roughened copper foil.
The low-roughened copper foil is preferably a copper foil having a surface roughness of 1.5 μm or less, more preferably a copper foil having a surface roughness of 1.4 μm or less, and particularly preferably a copper foil having a surface roughness of 1.3 μm or less.
The non-roughened copper foil is preferably a copper foil having a surface roughness of 0.85 μm or less, more preferably a copper foil having a surface roughness of 0.84 μm or less, and particularly preferably a copper foil having a surface roughness of 0.82 μm or less.
From the viewpoint of further improving the performance of a 5G wiring substrate of which the market size is expected to expand, it is expected to adopt a non-roughened copper foil of which the skin effect is reduced more than that of a low-roughened copper foil.
In the present embodiment, an adhesive-attached metal substrate and a laminate which can sufficiently ensure adhesive strength between a resin film and a metal layer are obtained even when a non-roughened copper foil is used as the metal layer 10, by forming an adhesive resin layer with a specific adhesive resin composition described later.
The surface roughness of a metal foil including a copper foil as an example can be measured by, for example, a laser microscope VK- 9700 manufactured by KEYENCE Corporation. The surface roughness in the present specification

means ten-point average roughness.

The thickness of the metal layer 10 is preferably 1 μm or more, more preferably 2 μm or more, and still more preferably 3 μm or more. Further, the thickness of the metal layer 10 is preferably 20 μm or less, more preferably 19 μm or less, and still more preferably 18 μm or less.

The upper limit value and the lower limit value of the thickness of the metal layer 10 can be optionally combined, and the thickness of the metal layer 10 is, for example, 1 μm or more and 20 μm or less, 2 μm or more and 19 μm or less, or 3 μm or more and 18 μm or less.

(Adhesive resin layer 11)

The adhesive resin layer 11 is formed of an adhesive resin composition described later.

According to the adhesive-attached metal substrate 1, the metal layer 10 and an optional low dielectric substrate can be bonded via the adhesive resin layer 11.

The thickness of the adhesive resin layer 11 included in the adhesive-attached metal substrate 1 is preferably 1 μm or more and 15 μm or less, more preferably 1.2 μm or more and 12 μm or less, still more preferably 1.4 μm or more and 9 μm or less, and particularly preferably 1.6 μm or more and 7 μm or less.

When the thickness of the adhesive resin layer 11 is the above lower limit value or more, the metal layer 10 and a low dielectric substrate can be bonded to each other.

When a specific adhesive resin composition described later is used in the case of bonding different types of materials such as the metal layer 10 and a low dielectric substrate to each other, adhesive strength is easily improved when the thickness of the adhesive resin layer 11 is in the range of the above upper limit value or less.

It is presumed that the reason for this is that when the thickness of the adhesive resin layer 11 is in the range of the above upper limit value or less, a dimensional change associated with a temperature change hardly occurs.

Since an FPC and a flexible copper clad laminate (FCCL) are formed by combining dissimilar materials such as a metal material and a resin material, their shapes are easily distorted due to a change in the use environment, particularly due to a temperature change. Therefore, with the use of the adhesive-attached metal substrate according to the present embodiment in which a dimensional change associated with a temperature change hardly occurs, an FPC or an FCCL in which distortion hardly occurs is easily obtained.

(Adhesive resin composition)

Hereinafter, an adhesive resin composition for forming the adhesive resin layer 11 will be described.

In the present embodiment, the adhesive resin layer 11 can be formed with a specific adhesive resin composition to provide, for example, an adhesive-attached metal substrate and a laminate which can exhibit low dielectric properties in a high frequency region of 10 GHz, which is a frequency band of 6 GHz or more when 5G is assumed.

It is considered that in a specific adhesive resin composition described later, the content of a maleimide compound which is one component of the precursor of the polyimide resin (A) satisfies a specific amount, so that the resulting adhesive resin layer 11 exhibits low dielectric properties in a high frequency region. The maleimide group of the maleimide compound maintains a cyclic structure even after crosslinking, and has a symmetrical structure when the maleimide groups are crosslinked to each other. In this case, it is considered that molecular motion is easily suppressed, and the resulting adhesive resin layer 11 exhibits low dielectric properties in a high frequency region.

The adhesive resin composition contains a polyimide resin (A), a maleimide compound (B), a radical initiator, and an epoxy resin.

As the adhesive resin composition, one obtained by adding a predetermined amount of an epoxy resin to the resin composition disclosed in International Publication WO 2022/004583 can be used.

This will be specifically described below.

[Polyimide resin (A)]

The polyimide resin (A) is an isocyanate-modified polyimide resin (A1) or a terminal-modified isocyanate-modified polyimide resin (A2). Hereinafter, the isocyanate-modified polyimide resin (A1) is referred to as a "polyimide resin (A1)", and the terminal-modified isocyanate-modified polyimide resin (A2) is referred to as a "polyimide resin (A2)".

· Polyimide resin (A1)

The polyimide resin (A1) is obtained by a reaction between a diisocyanate compound (a) and an intermediate polyimide resin. Hereinafter, the diisocyanate compound (a) is described as a "component (a)".

The intermediate polyimide resin is a reaction product of an aliphatic diamino compound (b) (hereinafter,

described as a "component (b)"), a tetrabasic acid dianhydride (c) (hereinafter, described as a "component (c)"), and an aromatic diamino compound (d) (hereinafter, described as a "component (d)").

The polyimide resin (A1) is a reaction product of either one or both of an amino group and an acid anhydride group at both terminals of the intermediate polyimide resin, and an isocyanate group of the component (a).

The reaction between the intermediate polyimide resin and the component (a) is a copolymerization reaction between an amino group or an acid anhydride group at the terminals of the intermediate polyimide resin, and an isocyanate group of the component (a). That is, it is a reaction in which a urea bond is formed by a reaction between an amino group and an isocyanate group, and an imide bond is formed by a reaction between an acid anhydride and an isocyanate group.

As the amount of the component (a) used in the copolymerization reaction between the intermediate polyimide resin and the component (a), the isocyanate group of the component (a) is preferably less than 1 equivalent, more preferably 0.50 to 0.99 equivalent, and still more preferably 0.67 to 0.98 equivalent, with respect to 1 equivalent of the terminal functional group of the intermediate polyimide resin.

By setting the use amount of the component (a) with respect to the intermediate polyimide resin within the above range, the polyimide resin (A1) has a sufficiently high molecular weight. Furthermore, the residual ratio of the unreacted raw material is reduced, and various properties such as heat resistance and flexibility after curing of the adhesive resin composition are improved.

Note that as described herein, the terminal functional group equivalent of the intermediate polyimide resin means a value calculated from the use amount of each material in synthesizing the intermediate polyimide resin.

The component (a) used in the synthesis of the polyimide resin (A1) is not particularly limited as long as it has two isocyanate groups in the molecule, and a plurality of diisocyanate compounds can be reacted at the same time.

The component (a) is preferably phenylene diisocyanate, tolylene diisocyanate, xylylene diisocyanate, tetramethylxylylene diisocyanate, diphenylmethane diisocyanate, naphthalene diisocyanate, tolydene diisocyanate, hexamethylene diisocyanate, dicyclohexylmethane diisocyanate, isophorone diisocyanate, allylene sulfone ether diisocyanate, allylcyan diisocyanate, N-acyl diisocyanate, trimethylhexamethylene diisocyanate, 1,3-bis(isocyanate methyl)cyclohexane, or norbornane-diisocyanate methyl. Among them, hexamethylene diisocyanate, trimethylhexamethylene diisocyanate, or isophorone diisocyanate, each being excellent in the balance among flexibility, adhesiveness, and the like, is more preferable.

The reaction between the intermediate polyimide resin and the component (a) may be performed by a known synthesis method.

Specifically, the polyimide resin (A1) can be obtained by adding the component (a) to an intermediate polyimide resin solution obtained by a later-described synthesis method, and heating and stirring the mixture at a temperature of 80°C or higher and 150°C or lower.

Note that the reaction time of the synthesis reaction of the intermediate polyimide resin or the reaction between the intermediate polyimide resin and the component (a) is greatly affected by the reaction temperature, but the reaction is preferably performed until the viscosity increase accompanying the progress of the reaction reaches equilibrium, and the maximum molecular weight is obtained. The reaction time is usually several tens of minutes to 10 hours.

In addition, the intermediate polyimide resin solution obtained as described above can be poured into a poor solvent such as water, methanol, or hexane to separate the generated polymer and thereafter subjected to a reprecipitation method thereby to obtain the solid content of the polyimide resin (A1).

· Polyimide resin (A2)

The polyimide resin (A2) has either one or both of an amino group and an acid anhydride group at both terminals. Therefore, the terminal can be modified by reacting with a compound having one functional group capable of reacting with these functional groups to prepare a terminal-modified isocyanate-modified polyimide resin, i.e., the polyimide resin (A2).

Examples of the compound capable of reacting with either one or both of an amino group and an acid anhydride group include a compound having an acid anhydride group such as maleic anhydride, a compound having an alcoholic hydroxyl group such as hydroxyethyl acrylate, a compound having a phenolic hydroxyl group such as phenol, a compound having an isocyanate group such as 2-methacryloyloxyethyl isocyanate, and a compound having an epoxy group such as glycidyl methacrylate.

Since both terminals of the isocyanate compound of the present invention can be converted into functional groups other than an amino group and an acid anhydride group by modifying the terminals (for example, when terminal modification is performed with hydroxyethyl acrylate, the terminal of the isocyanate-modified polyimide resin can be converted into an acryloyl group), it is also possible to provide a composition combined with a compound that reacts with a functional group other than an amino group or an acid anhydride group.

· · Intermediate polyimide resin

The intermediate polyimide resin is a reaction product of the component (b), the component (c), and the component (d) described above.

The reaction of the component (b), the component (c), and the component (d) includes: a step of obtaining a polyamic acid by a copolymerization reaction between an amino group in the component (b) and the component (d) and an acid anhydride group in the component (c); and a step of obtaining an intermediate polyimide resin by a cyclodehydration reaction (imidization reaction) of the polyamic acid. These two steps may be performed separately, but it is efficient to perform them continuously and collectively.

When the number of moles of the component (b) used in the copolymerization reaction is MB, the number of moles of the component (c) is MC, and the number of moles of the component (d) is MD, both terminals of the obtained intermediate polyimide resin are amino groups in a case where the relationship of MB + MD > MC is satisfied, and both terminals of the obtained intermediate polyimide resin are acid anhydride groups in a case where the relationship of MB + MD < MC is satisfied.

Further, in a case where the relationship of MB + MD = MC is satisfied, the molecular weight of the obtained intermediate polyimide resin theoretically reaches infinity, and one amino group and one acid anhydride group are included at both terminals.

An example of the amount of the component (b) used in the copolymerization reaction is preferably an amount in a range of 10 mass% or more and 50 mass% or less of a mass (this mass is substantially equal to the mass of the finally obtained isocyanate-modified polyimide resin) obtained by subtracting the mass of water generated in the cyclodehydration reaction step during synthesis of the intermediate polyimide resin from the sum of the mass of the component (b), the component (c), and the component (d) used in the synthesis step of the intermediate polyimide resin and the mass of the component (a) used in the above-described synthesis step of the polyimide resin (A1).

When the amount of the component (b) is less than the above range, the proportion of the aliphatic chain derived from the component (b) in the intermediate polyimide resin is too small, and the dielectric constant and the dielectric loss tangent become high. When the amount of the component (b) exceeds the above range, the proportion of the aliphatic chain derived from the component (b) in the intermediate polyimide resin is too large, and the heat resistance of the cured product is lowered.

The component (b) used for the synthesis of the intermediate polyimide resin is not particularly limited as long as it is an aliphatic compound having two amino groups in one molecule, but an aliphatic diamino compound having 6 to 36 carbon atoms is preferable.

Specific examples of the component (b) include hexamethylenediamine, 1,3-bis(aminomethyl)cyclohexane, a C14 branched diamine, a C18 branched diamine, a dimer diamine, and diaminopolysiloxane. These may be used individually or as a mixture of two or more thereof.

The dimer diamine described as a specific example of the component (b) is, as described herein, one in which two carboxy groups of a dimer acid as a dimer of an unsaturated fatty acid such as oleic acid are substituted with primary amino groups (for example, see Japanese Unexamined Patent Application, First Publication No. H9-012712).

Specific examples of a commercially available product of the dimer diamine include PRIAMINE 1074 and PRIAMINE 1075 (manufactured by Croda Japan KK) and Versamine 551 (manufactured by Cognis Japan Co., Ltd.). These may be used individually or as a mixture of two or more thereof.

The component (c) used for the synthesis of the intermediate polyimide resin is not particularly limited as long as it has two acid anhydride groups in one molecule.

Specific examples of the component (c) include pyromellitic anhydride, ethylene glycol-bis(anhydrotrimellitate), glycerin-bis(anhydrotrimellitate)monoacetate, 1,2,3,4-butanetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, 3,3',4,4'-diphenyl ether tetracarboxylic dianhydride, 5-(2,5-dioxotetrahydro-3-furanyl)-3-methylcyclohexene-1,2-dicarboxylic anhydride, 3a,4,5,9b-tetrahydro-5-(tetrahydro-2,5-dioxo-3-furanyl)-1,3-dione, 1,2,4,5-cyclohexanetetracarboxylic dianhydride, bicyclo(2,2,2)-oct-7-ene-2,3,5,6-tetracarboxylic dianhydride, bicyclo [2.2.2] octane - 2,3,5, 6-tetracarboxylic dianhydride, and 5,5'-((propane-2,2-diylbis(4,1-phenylene))bis(oxy))bis(isobenzofuran-1, 3-dione).

Among them, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, or 3,3',4,4'-diphenyl ether tetracarboxylic dianhydride is preferable from the viewpoint of solvent solubility, adhesion to a substrate, and photosensitivity. These may be used individually or as a mixture of two or more thereof.

The component (c) used for the synthesis of the intermediate polyimide resin preferably contains at least one compound selected from the group consisting of chemical formulas (1) to (4).

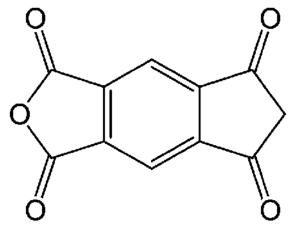

(1)

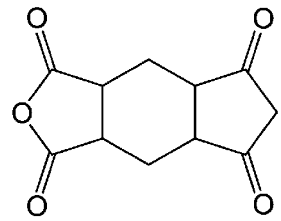

(2)

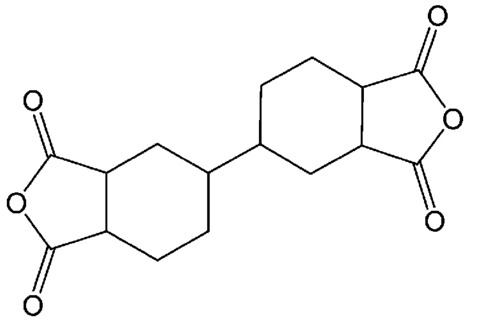

(3)

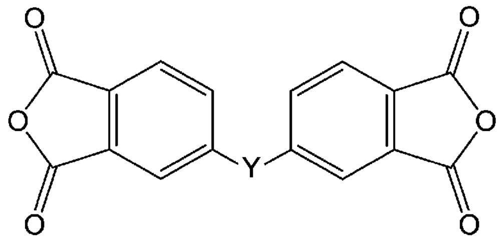

(4)

In chemical formula (4), Y represents $C(CF_3)_2$, $SO_2$, CO, O, a direct bond, or a divalent linking group represented by chemical formula (5) below. Note that the two linking moieties represented by chemical formula (5) are each a moiety that binds to a phthalic anhydride.

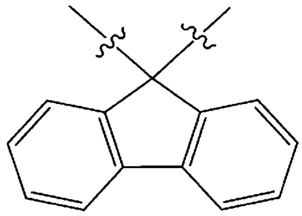

(5)

The component (d) used for the synthesis of the intermediate polyimide resin is not particularly limited as long as it is an aromatic compound having two amino groups in one molecule.

Specific examples of the component (d) include m-phenylenediamine, p-phenylenediamine, m-tolylenediamine, 4,4'-diaminodiphenyl ether, 3,3'-dimethyl-4,4'-diaminodiphenyl ether, 3,4'-diaminodiphenyl ether, 4,4'-diaminodiphenyl thioether, 3,3'-dimethyl-4,4'-diaminodiphenyl thioether, 3,3'-diethoxy-4,4'-diaminodiphenyl thioether, 3,3'-diaminodiphenyl thioether, 4,4'-diaminobenzophenone, 3,3'-dimethyl-4,4'-diaminobenzophenone, 3,3'-diaminodiphenylmethane, 4,4'-diaminodiphenylmethane, 3,4'-diaminodiphenylmethane, 3,3'-dimethoxy-4,4'-diaminodiphenylthioether, 2,2'-bis(3-aminophenyl)propane, 2,2'-bis(4-aminophenyl)propane, 4,4'-diaminodiphenyl sulfoxide, 3,3'-diaminodiphenyl sulfone, 4,4'-diaminodiphenyl sulfone, benzidine, 3,3'-dimethylbenzidine, 3,3'-dimethoxybenzidine, 3,3'-diaminobiphenyl, p-xylylenediamine, m-xylylenediamine, o-xylylenediamine, 2,2'-bis(3-aminophenoxyphenyl)propane, 2,2'-bis(4-aminophenoxyphenyl)propane, 1,3-bis(4-aminophenoxyphenyl)benzene, 1,3'-bis(3-aminophenoxyphenyl)propane, bis(4-amino-3-methylphenyl)methane, bis(4-amino-3,5-dimethylphenyl)methane, bis(4-amino-3-ethylphenyl)methane, bis(4-amino-3,5-diethylphenyl)methane, bis(4-amino-3-propylphenyl)methane, and bis(4-amino-3,5-dipropylphenyl) methane. These may be used individually or as a mixture of two or more thereof.

The component (d) used for the synthesis of the intermediate polyimide resin preferably contains at least one compound selected from the group consisting of chemical formulas (6) and (8) below.

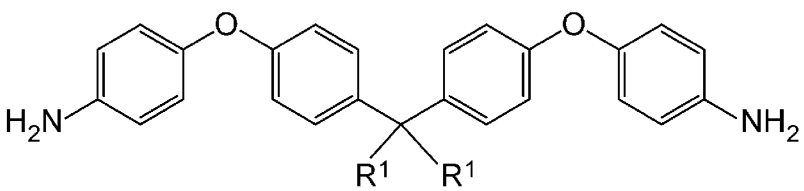

(6)

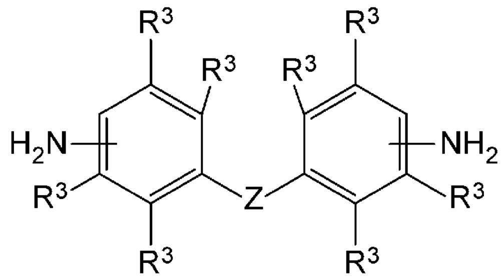

(8)

In chemical formula (6), $R^1$ represents a methyl group or a trifluoromethyl group. In chemical formula (8), Z represents $CH(CH_3)$, $SO_2$, $CH_2$, O-$C_6H_4$-O, O, a direct bond, or a divalent linking group represented by chemical formula (5) above, and $R^3$ represents a hydrogen atom, a methyl group, an ethyl group, or a trifluoromethyl group. Note that the two linking moieties represented by chemical formula (5) are each a moiety that binds to a phthalic anhydride.

The intermediate polyimide resin can be synthesized by a known method.

For example, a solvent, a dehydrating agent, and a catalyst are added to a mixture of the components (b) to (d) used for synthesis, and the mixture is heated and stirred at 100 to 300°C under an inert gas atmosphere such as nitrogen, so that an imidization reaction (ring-closing reaction accompanied by dehydration) occurs through a polyamic acid, and an intermediate polyimide resin solution is obtained. At this time, water generated in association with imidization is distilled off to the outside of the system, and the dehydrating agent and the catalyst are also distilled off to the outside of the system after the completion of the reaction, so that an intermediate polyimide resin having high purity can be obtained without requiring washing. Examples of the dehydrating agent include toluene and xylene, and examples of the catalyst include pyridine and triethylamine.

Examples of the solvent usable in the synthesis of the intermediate polyimide resin include, but are not limited to, methyl ethyl ketone, methyl propyl ketone, methyl isopropyl ketone, methyl butyl ketone, methyl isobutyl ketone, methyl n-hexyl ketone, diethyl ketone, diisopropyl ketone, diisobutyl ketone, cyclopentanone, cyclohexanone, methyl cyclohexanone, acetylacetone, γ-butyrolactone, diacetone alcohol, cyclohexen-1-one, dipropyl ether, diisopropyl ether, dibutyl ether, tetrahydrofuran, tetrahydropyran, ethyl isoamyl ether, ethyl-t-butyl ether, ethyl benzyl ether, cresyl methyl ether, anisole, phenetol, methyl acetate, ethyl acetate, propyl acetate, isopropyl acetate, butyl acetate, isobutyl acetate, amyl acetate, isoamyl acetate, 2-ethylhexyl acetate, cyclohexyl acetate, methyl cyclohexyl acetate, benzyl acetate, methyl acetoacetate, ethyl acetoacetate, methyl propionate, ethyl propionate, butyl propionate, benzyl propionate, methyl butyrate, ethyl butyrate, isopropyl butyrate, butyl butyrate, isoamyl butyrate, methyl lactate, ethyl lactate, butyl lactate, ethyl isovalerate, isoamyl isovalerate, diethyl oxalate, dibutyl oxalate, methyl benzoate, ethyl benzoate, propyl benzoate, methyl salicylate, N-methylpyrrolidone, N,N-dimethylformamide, N,N-dimethylacetamide, and dimethyl sulfoxide. These may be used individually or as a mixture of two or more thereof.

[Maleimide compound (B)]

The maleimide compound (B) is not particularly limited as long as it is a compound having one or more maleimide groups in one molecule, but a compound having two or more maleimide groups in one molecule is preferable. Examples thereof include a polyfunctional maleimide compound obtained by a reaction of 3,4,4'-triaminodiphenylmethane, triaminophenol, or the like with maleic anhydride, a maleimide compound obtained by a reaction of tris-(4-aminophenyl)-phosphate, tris(4-aminophenyl)-phosphate, or toss(4-aminophenyl)-thiophosphate with maleic anhydride, a trismaleimide compound such as tris(4-maleimidephenyl)methane, a tetramaleimide compound such as bis(3,4-dimaleimidephenyl) methane, tetramaleimidebenzophenone, tetramaleimidenaphthalene, or a maleimide obtained by a reaction between triethylenetetramine and maleic anhydride, a phenol novolac-type maleimide resin, an isopropylidenebis(phenoxyphenylmaleimide)phenylmaleimidearalkyl resin, and biphenylene-type phenylmaleimidearalkyl resin. Examples of the commercially available product include MIR-3000 and MIR-5000 (manufactured by Nippon Kayaku Co., Ltd.), BMI-70 and BMI-80 (manufactured by K.I Chemical Industry Co., Ltd.), and BMI-1000, BMI-2000, and BMI-3000 (manufactured by Daiwa Kasei Industrial Co., Ltd.).

Since maleimide groups in a maleimide compound are self-crosslinked by the action of a radical initiator, a resin composition using an isocyanate-modified polyimide resin having an amino group at the terminal, a maleimide compound, and a radical initiator becomes a cured product in which maleimide groups are self-crosslinked by heating, and a polyimide resin and a maleimide resin are copolymerized.

[Radical initiator]

Examples of the radical initiator usable for the self-crosslinking between maleimide groups include peroxides

such as dicumyl peroxide and dibutyl peroxide and azo compounds such as 2,2'-azobis(isobutyronitrile) and 2,2'-azobis(2,4-dimethylvaleronitrile).

[Epoxy resin]

The epoxy resin is preferably a bifunctional or higher functional epoxy resin. Examples thereof include a bisphenol A type epoxy resin, a bisphenol F type epoxy resin, a phenol novolac type epoxy resin, a glycidylamine type epoxy resin, and a phenoxy resin which is a reaction product between a bisphenol type epoxy resin and epichlorohydrin.
Examples of such an epoxy resin include, but are not particularly limited to, jER (registered trademark) 154, jER157, jER1031, jER1032, jER630, jER1001, and jER1256 (manufactured by Mitsubishi Chemical Corporation), EPICLON (registered trademark) N-740 and EPICLON N-770 (manufactured by DIC Corporation), YDPN-638, YDCN-700, and YH-434 (manufactured by Nippon Steel Chemical & Material Co., Ltd.), and TETRAD (registered trademark) -X and TETRAD-C (manufactured by Mitsubishi Gas Chemical Company, Inc.).
Further, as commercially available products of the epoxy resin, HP-4032D and HP-7200 manufactured by DIC Corporation and NC-3000 manufactured by Nippon Kayaku Co., Ltd. can be used.
The mass ratio between the polyimide resin (A) and the maleimide compound (B) in the adhesive resin composition used in the present embodiment is 10:1 to 3:2 and preferably 7:1 to 5:2.
When the mass ratio between the polyimide resin (A) and the maleimide compound (B) is in the above range, an adhesive-attached metal substrate and a laminate which have low dielectric properties in a high frequency region are obtained. In addition, even a metal foil having a low surface roughness of 1.5 $\mu$m or less is likely to adhere and exert high adhesive strength.
The content of the radical initiator in the adhesive resin composition used in the present embodiment, with respect to 100 parts by mass of the maleimide compound (B), is equal to or more than 1 part by mass and less than 15 parts by mass and preferably 4 parts by mass or more and 10 parts by mass or less.
When the content of the radical initiator satisfies the above range, an adhesive-attached metal substrate and a laminate which can sufficiently ensure adhesive strength between a resin film and a metal layer are obtained. In particular, even a metal foil having a low surface roughness of 1.5 $\mu$m or less is likely to adhere and exhibit high adhesive strength.
The content of the epoxy resin in the adhesive resin composition used in the present embodiment, with respect to 100 parts by mass of the polyimide resin (A) and the maleimide compound (B) in total, is 1 part by mass or more and 5 parts by mass or less.
When the content of the epoxy resin is the above lower limit value or more, the epoxy group remaining without completely reacting with the polyimide group of the polyimide resin can be chemically bonded (for example, hydrogen bonding) to the surface of the metal layer, so that even when non-roughened copper is used as the metal layer, an adhesive-attached metal substrate and a laminate which can sufficiently ensure adhesive strength between a resin film and a metal layer are obtained.
When the content of the epoxy resin is the above upper limit value or less, an adhesive-attached metal substrate and a laminate which can sufficiently ensure adhesive strength between a resin film and a metal layer while maintaining low dielectric properties are obtained even when non-roughened copper is used as the metal layer.
The adhesive resin composition used in the present embodiment may contain an organic solvent.
Specific examples of the organic solvent include $\gamma$-butyrolactones; amide-based solvents such as N-methylpyrrolidone, N,N-dimethylformamide, N,N-dimethylacetamide, and N,N-dimethylimidazolidinone; sulfones such as tetramethylene sulfone; ether-based solvents such as diethylene glycol dimethyl ether, diethylene glycol diethyl ether, propylene glycol, propylene glycol monomethyl ether, propylene glycol monomethyl ether monoacetate, and propylene glycol monobutyl ether; ketone-based solvents such as methyl ethyl ketone, methyl isobutyl ketone, cyclopentanone, and cyclohexanone; and aromatic solvents such as toluene and xylene.
The organic solvent is preferably used in such a ratio that the solid content concentration in the adhesive resin composition excluding the organic solvent is usually 10 mass% or more and 80 mass% or less and preferably 20 mass% or more and 70 mass% or less.
The adhesive resin composition can be produced by adding a main agent containing the polyimide resin (A) and the maleimide compound (B) to an organic solvent, and further adding the radical initiator and the epoxy resin.

<Laminate>

The laminate of the present embodiment includes the adhesive-attached metal substrate of the present embodiment on one surface or both surfaces of a resin film.
Fig. 2 is a cross-sectional schematic view of a laminate 2 of the present embodiment. The laminate 2 includes the adhesive-attached metal substrate 1 on both surfaces of a resin film 12.
The resin film 12 is laminated on a surface 11a opposite a surface on which the adhesive resin layer 11 of the

adhesive-attached metal substrate 1 is in contact with the metal layer 10.

That is, the laminate 2 includes the metal layer 10, the adhesive resin layer 11, the resin film 12, the adhesive resin layer 11, and the metal layer 10 laminated in this order.

When the laminate of the present embodiment includes the adhesive-attached metal substrate of the present embodiment on one surface of a resin film, the metal layer 10, the adhesive resin layer 11, and the resin film 12 are laminated in this order.

(Resin film)

The resin film 12 is preferably one or more selected from the group consisting of a modified polyimide resin film, a polyester resin film, a liquid crystal polymer film, a cyclic olefin resin film, a polyphenylene ether resin film, a polyphenylene sulfide resin film, a polyether ether ketone resin film, a bismaleimide resin film, a triazine resin film, a benzocyclobutene resin film, and a low dielectric epoxy resin film.

In the laminate 2, the thickness of the adhesive resin layer 11 is preferably 1 μm or more and 15 μm or less. The thickness of the resin film 12 is preferably 38 μm or more and 100 μm or less. The thickness of the metal layer 10 is preferably 3 μm or more and 18 μm or less.

The thickness X (μm) of the adhesive resin layer 11 and the thickness Y (μm) of the resin film 12 preferably satisfy the relationship of mathematical formula (1) below.

$$1\% \leqq (X/Y) \times 100 \leqq 8\% \quad \cdots (1)$$

When X/Y is the above lower limit value or more, the metal layer 10 and the resin film 12 can be sufficiently bonded.

It is considered that when X/Y is the above upper limit value or less, the thickness of the adhesive resin layer 11 is thinner than that of the resin film 12, and the influence of a dimensional change of the adhesive resin layer 11 associated with a temperature change on the resin film 12 is reduced. It is presumed that this inhibits a reduction in adhesive strength even after a temperature change.

An example of the laminate 2 is a flexible copper clad laminate (FCCL) or a copper clad laminate (CCL).

EXAMPLES

Hereinafter, the present invention will be described more specifically as examples, but the present invention is not limited to these examples.

< Preparation of adhesive resin composition >

· Adhesive resin composition 1

The polyimide resin (A) and the maleimide compound (B) were mixed at a mass ratio of 10:3 to form a main agent, and the main agent was dissolved in anisole. Subsequently, 3 parts by mass of dicumyl peroxide (manufactured by Sigma-Aldrich Co. LLC.) was added to 100 parts by mass of the maleimide compound (B), and 1 part by mass of tetrafunctional glycidylamine (TETRAD-X manufactured by Mitsubishi Gas Chemical Company, Inc.) was further added as an epoxy resin to 100 parts by mass of the polyimide resin (A) and the maleimide compound (B) in total to prepare an adhesive resin composition 1 having a solid concentration of 20 mass%.

· Adhesive resin composition 2

An adhesive resin composition 2 was prepared in the same manner as the adhesive resin composition 1 except that the blending amount of the epoxy resin was changed to 5 parts by mass.

·Adhesive resin composition 3

An adhesive resin composition 3 was prepared in the same manner as the adhesive resin composition 1 except that no epoxy resin was blended.

·Adhesive resin composition 4

An adhesive resin composition 4 was prepared in the same manner as the adhesive resin composition 1 except

that the blending amount of the epoxy resin was 10 parts by mass.

<Production of adhesive-attached metal substrate>

The obtained adhesive resin compositions 1 to 4 were each applied on a non-roughened copper foil and a low-roughened copper foil as a metal layer using an applicator such that the thickness of the adhesive resin layer after drying was 6 μm, and thereafter dried at 120°C for 10 minutes to produce adhesive-attached metal substrates 1 to 8 of Examples 1 and 2 and Comparative Examples 1 and 2 illustrated in Table 1.

Note that an electroless copper foil (CF-T9DA-SV-12 manufactured by Fukuda Metal Foil & Powder Co., Ltd.) having a surface roughness of 0.85 μm and a thickness of 12 μm was used as the non-roughened copper foil, and an electroless copper foil (CF-T49A-DS-HD2-12 manufactured by Fukuda Metal Foil & Powder Co., Ltd.) having a surface roughness of 1.2 μm and a thickness of 12 μm was used as the low-roughened copper foil.

[Table 1]

| | | Metal layer | Adhesive resin layer |
|---|---|---|---|
| Example 1 | Adhesive-attached metal substrate 1 | Non-roughened copper foil | Adhesive resin composition 1 |
| | Adhesive-attached metal substrate 2 | Low-roughened copper foil | |
| Example 2 | Adhesive-attached metal substrate 3 | Non-roughened copper foil | Adhesive resin composition 2 |
| | Adhesive-attached metal substrate 4 | Low-roughened copper foil | |
| Comparative Example 1 | Adhesive-attached metal substrate 5 | Non-roughened copper foil | Adhesive resin composition 3 |
| | Adhesive-attached metal substrate 6 | Low-roughened copper foil | |
| Comparative Example 2 | Adhesive-attached metal substrate 7 | Non-roughened copper foil | Adhesive resin composition 4 |
| | Adhesive-attached metal substrate 8 | Low-roughened copper foil | |

<Production of laminate>

The adhesive-attached metal substrates 1 to 8 of Examples 1 and 2 and Comparative Examples 1 and 2 were each laminated on both surfaces of a modified polyimide film having a thickness of 38 μm previously dried at 105°C for 60 minutes as a resin film, such that the copper foil (metal layer), the adhesive resin layer, the modified polyimide film (resin film), the adhesive resin layer, and the copper foil (metal layer) were laminated in this order. Thereafter, the laminate was laminated under the lamination conditions of 200°C, 120 minutes, and 3 MPa to produce each of laminates 1 to 8 of Examples 1 and 2 and Comparative Examples 1 and 2 illustrated in Table 2.

<Measurement of adhesive strength>

For the obtained laminate, the adhesive strength between the copper foil and the modified polyimide film was measured. The obtained laminate was cut into a width of 10 mm to prepare a test piece, the modified polyimide film side was pasted on a ring core having a diameter of 11 cm, and the copper foil portion was pulled at a speed of 50 mm/min to perform a 90° peel test.

In this measurement, the case where the adhesive strength was 0.7 N/mm or more for a non-roughened copper foil was evaluated as "adhesive strength can be sufficiently ensured". The adhesive strength of each of Examples 1 and 2 and Comparative Examples 1 and 2 is illustrated in Table 2.

Note that the adhesive strength when a low-roughened copper foil is used is also illustrated as a reference value in Table 2.

For the non-roughened copper foil, the adhesive strength is required to be 0.7 N/mm or more as an index of adhesive strength between the resin film and the metal layer, from the viewpoint of preventing peeling of the metal layer in the production process of an FPC. Therefore, 0.7 N/mm was defined as an acceptable value.

[Table 2]

| | | Adhesive-attached metal substrate | Resin film | Adhesive strength (N/mm) |
|---|---|---|---|---|
| Example 1 | Laminate 1 | Adhesive-attached metal substrate 1 | Modified polyimide film | 0.7 |
| | Laminate 2 | Adhesive-attached metal substrate 2 | Modified polyimide film | 0.8 |
| Example 2 | Laminate 3 | Adhesive-attached metal substrate 3 | Modified polyimide film | 0.8 |
| | Laminate 4 | Adhesive-attached metal substrate 4 | Modified polyimide film | 0.8 |
| Comparative Example 1 | Laminate 5 | Adhesive-attached metal substrate 5 | Modified polyimide film | 0.4 |
| | Laminate 6 | Adhesive-attached metal substrate 6 | Modified polyimide film | 0.8 |
| Comparative Example 2 | Laminate 7 | Adhesive-attached metal substrate 7 | Modified polyimide film | 0.7 |
| | Laminate 8 | Adhesive-attached metal substrate 8 | Modified polyimide film | 0.8 |

<Measurement of dielectric properties>

The adhesive resin compositions 1 to 4 were each applied on a peeling-treated polyimide film using an applicator such that the thickness of the adhesive resin layer after drying was 40 μm and thereafter dried at 120°C for 10 minutes to obtain each of single layer sheets 1 to 4 illustrated in Table 3.

The obtained single layer sheets 1 to 4 were dried at 135°C for 1 hour to obtain test pieces "after drying". After drying, the test pieces were further left to stand under the conditions of 23°C and a humidity of 50% for 24 hours to obtain test pieces "after humidity control", and dielectric properties of the test pieces were measured.

For dielectric properties, the relative permittivity and the dielectric loss tangent were measured at a frequency of 10 GHz by a split-post dielectric resonator method using a resonator manufactured by QWED.

A relative permittivity of 3.0 or less was evaluated as "low relative permittivity".

A dielectric loss tangent of 0.003 or less after drying was defined as "low dielectric loss tangent", and a dielectric loss tangent of 0.005 or less after humidity control was defined as "low dielectric loss tangent".

The case where both the above relative permittivity and dielectric loss tangent are satisfied was evaluated that dielectric properties in a high frequency region are low.

[Table 3]

| | Adhesive resin layer | Resin film | Relative permittivity | | Dielectric loss tangent | |
|---|---|---|---|---|---|---|
| | | | After drying | After humidity control | After drying | After humidity control |
| Single layer sheet 1 | Adhesive resin composition 1 | Polyimide film | 2.7 | 2.7 | 0.002 | 0.003 |
| Single layer sheet 2 | Adhesive resin composition 2 | Polyimide film | 2.8 | 2.7 | 0.003 | 0.005 |
| Single layer sheet 3 | Adhesive resin composition 3 | Polyimide film | 2.6 | 2.7 | 0.002 | 0.003 |
| Single layer sheet 4 | Adhesive resin composition 4 | Polyimide film | 2.8 | 2.7 | 0.005 | 0.006 |

As illustrated in Table 3, the single layer sheets 1 and 2 maintained low dielectric properties in a high frequency region.

From the results of Tables 2 and 3, it was confirmed that the laminates of Examples 1 and 2 including adhesive resin layers corresponding to the single layer sheets 1 and 2 satisfied the acceptance value of adhesive strength while maintaining low dielectric properties in a high frequency region even when a low-roughened copper foil was used. Furthermore, for the non-roughened copper foil, it was confirmed that the adhesive strength of Example 2 was improved more than that of Example 1.

It is considered that this is because the epoxy group remaining without completely reacting with the polyimide group of the polyimide resin was chemically bonded (for example, hydrogen bonding) to the surface of the metal layer, so that the adhesive strength between the resin film and the metal layer could be sufficiently ensured even when a non-roughened copper foil or a low-roughened copper foil was used as the metal layer.

On the other hand, in Comparative Example 1, the adhesive strength did not satisfy the acceptance value in the

case of a non-roughened copper foil. It is considered that this is because the adhesive resin layer of Comparative Example 1 did not contain an epoxy resin, so that adhesion to the surface of the non-roughened copper foil by chemical bonding could not be achieved.

In the case of a non-roughened copper foil in Comparative Example 2, the adhesive strength satisfied the acceptance value, but the dielectric properties were deteriorated. It is considered that this is because an epoxy resin has a highly polar molecular structure, so that the dielectric loss tangent did not satisfy the acceptance value in the present specification when the added amount exceeded 5 parts by mass.

REFERENCE SIGNS LIST

| | |
|---|---|
| 1 | Adhesive-attached metal substrate |
| 2 | Laminate |
| 10 | Metal layer |
| 11 | Adhesive resin layer |
| 12 | Resin film |

## Claims

**1.** An adhesive-attached metal substrate comprising a metal layer and an adhesive resin layer formed of an adhesive resin composition,

wherein the adhesive resin composition contains a polyimide resin (A), a maleimide compound (B), a radical initiator, and an epoxy resin,
a mass ratio between the polyimide resin (A) and the maleimide compound (B) is 10:1 to 3:2,
the content of the radical initiator, with respect to 100 parts by mass of the maleimide compound (B), is equal to or more than 1 part by mass and less than 15 parts by mass, and
the content of the epoxy resin, with respect to 100 parts by mass of the polyimide resin (A) and the maleimide compound (B) in total, is 1 part by mass or more and 5 parts by mass or less.

**2.** The adhesive-attached metal substrate according to claim 1, wherein the metal layer is a copper foil having a surface roughness of 1.5 $\mu$m or less.

**3.** The adhesive-attached metal substrate according to claim 1 or 2, wherein the adhesive resin layer has a thickness of 1 $\mu$m or more and 15 $\mu$m or less.

**4.** A laminate comprising the adhesive-attached metal substrate according to any one of claims 1 to 3 on one surface or both surfaces of a resin film,

wherein the resin film is laminated on a surface opposite a surface on which the adhesive resin layer included in the adhesive-attached metal substrate is in contact with the metal layer, and
the resin film is one or more selected from the group consisting of a modified polyimide resin film, a polyester resin film, a liquid crystal polymer film, a cyclic olefin resin film, a polyphenylene ether resin film, a polyphenylene sulfide resin film, a polyether ether ketone resin film, a bismaleimide resin film, a triazine resin film, a benzocyclobutene resin film, and a low dielectric epoxy resin film.

Fig. 1

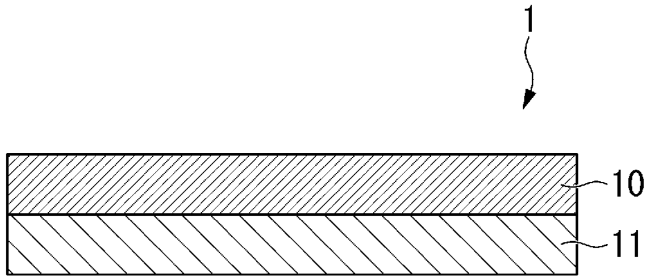


Fig. 2

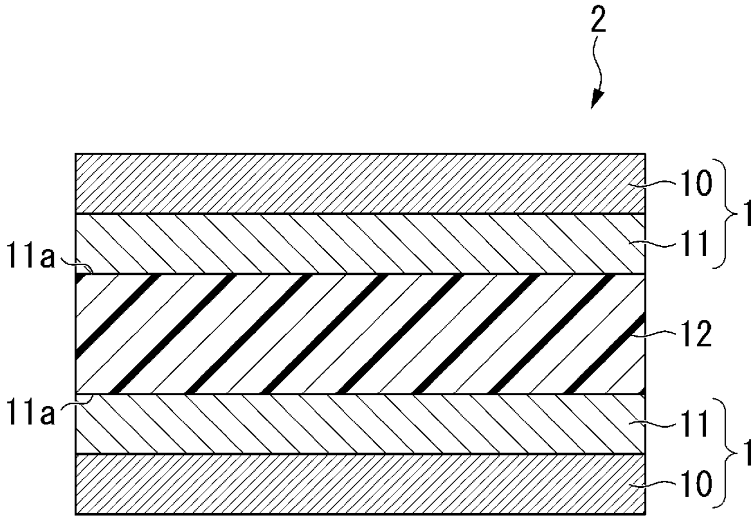

**INTERNATIONAL SEARCH REPORT**

International application No.
**PCT/IB2023/053046**

**A. CLASSIFICATION OF SUBJECT MATTER**

***B32B 15/088***(2006.01)i; ***H05K 1/03***(2006.01)i
FI: B32B15/088; H05K1/03 610H

According to International Patent Classification (IPC) or to both national classification and IPC

**B. FIELDS SEARCHED**

Minimum documentation searched (classification system followed by classification symbols)

B32B15/088; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/004583 A1 (NIPPON KAYAKU KABUSHIKI KAISHA) 06 January 2022 (2022-01-06) | 1-4 |
| A | WO 2020/189354 A1 (NIPPON KAYAKU KABUSHIKI KAISHA) 24 September 2020 (2020-09-24) | 1-4 |
| A | JP 2018-41961 A (ARAKAWA CHEM IND) 15 March 2018 (2018-03-15) | 1-4 |
| A | JP 2017-121807 A (ARAKAWA CHEM IND) 13 July 2017 (2017-07-13) | 1-4 |
| A | JP 2021-161130 A (TOYOBO CO., LTD.) 11 October 2021 (2021-10-11) | 1-4 |
| P, X | JP 2023-39241 A (NIPPON KAYAKU KABUSHIKI KAISHA) 20 March 2023 (2023-03-20) paragraph [0072], example 6 | 1-2, 4 |
| P, A | | 3 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 June 2023** | **13 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/IB2023/053046**

| Patent document cited in search report | Publication date (day/month/year) | Patent family member(s) | Publication date (day/month/year) |
|---|---|---|---|
| WO 2022/004583 A1 | 06 January 2022 | TW 202219116 A | |
| WO 2020/189354 A1 | 24 September 2020 | US 2022/0169791 A1 | |
| | | CN 113474380 A | |
| | | KR 10-2021-0138632 A | |
| | | TW 202041572 A | |
| JP 2018-41961 A | 15 March 2018 | CN 107793991 A | |
| | | KR 10-2018-0027373 A | |
| | | TW 201825638 A | |
| JP 2017-121807 A | 13 July 2017 | KR 10-2017-0082130 A | |
| | | CN 107009697 A | |
| | | TW 201736118 A | |
| JP 2021-161130 A | 11 October 2021 | (Family: none) | |
| JP 2023-39241 A | 20 March 2023 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021003886 A
- WO 2022004583 A
- JP H9012712 A